# EUROPEAN PATENT SPECIFICATION

(11) **EP 2 071 350 B1**
(45) Date of publication and mention of the grant of the patent: **25.03.2015**
(21) Application number: 07713902.0
(22) Date of filing: 07.02.2007
(51) Int. Cl.: G01R 33/09, H01L 43/08

(54) **MAGNETISM DETECTING APPARATUS**
MAGNETISMUSDETEKTIONSVORRICHTUNG
APPAREIL DE DÉTECTION DE MAGNÉTISME

(30) Priority: 31.08.2006 JP 2006236492
(43) Date of publication of application: 17.06.2009
(73) Proprietor: Alps Electric Co., Ltd., Ota-ku Tokyo 145-8501 (JP)
(72) Inventor: KIKUIRI, Katsuya, Tokyo 145-8501 (JP); SATO, Kiyoshi, Tokyo 145-8501 (JP)
(74) Representative: Klunker . Schmitt-Nilson . Hirsch
(86) International application number: PCT/JP2007/052104
(87) International publication number: WO 2008/026329

(56) References cited:
- JP-A- 09 178 864
- JP-A- 59 159 565
- JP-A- H08 160 114
- JP-A- 2000 314 603
- US-B2- 7 023 310

## Description

### Technical Field

The present invention relates to a magnetic detection device having magnetic-resistance elements, and more particularly, to a magnetic detection device of an NS detection type capable of simplifying a circuit configuration with a decrease in the number of elements.

### Background Art

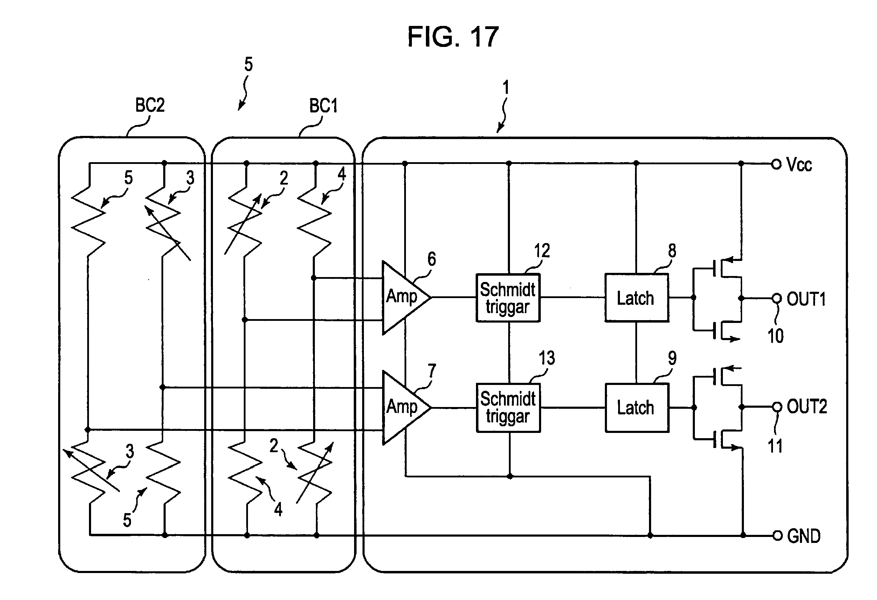

Fig. 17 is a circuit diagram of a known magnetic detection device. The magnetic detection device includes a sensor unit S and an integrated circuit (IC) 1. The magnetic detection device shown in Fig. 17 is an NS detection type sensor. The sensor unit S has a first bridge circuit BC1 including first magneto-resistance effect elements 2 such as a GMR element of which electric resistance varies with an external magnetic field in a positive direction and a second bridge circuit BC2 including second magneto-resistance effect elements 3, such as a GMR element of which electric resistance varies with an external magnetic field in a negative direction. "An external magnetic field in a positive direction" indicates the external magnetic field in a direction, in Fig. 17, that indicates the external magnetic field in the direction in which the resistance of the first magneto-resistance effect elements 2 varies but the resistance of the second magneto-resistance effect elements 3 does not vary (i.e. functions as a fixed resistance). "An external magnetic field in a negative direction" indicates an opposite direction of the external magnetic field in the positive direction, and in Fig. 20, that indicates the direction of the external magnetic field in which the resistance of the second magneto-resistance effect elements 3 varies but the resistance of the first magneto-resistance effect elements 2 does not vary (i.e. functions as fixed resistance).

As shown in Fig. 17, the first magneto-resistance effect elements 2 and fixed resistance elements 4 form series circuits respectively, and the series circuits are connected in parallel to each other to form the first bridge circuit BC1. Each output extracting portion of two series circuits forming the first bridge circuit BC1 is connected to a first differential amplifier 6. As shown in Fig. 17, the second magneto-resistance effect elements 3 and fixed resistance elements 5 form series circuits respectively, and the series circuits are connected in parallel to each other to form the second bridge circuit BC2. Each output extracting portion of two series circuits forming the second bridge circuit BC2 is connected to a second differential amplifier 7.

Inside the integrated circuit 1 is provided with not only the differential amplifiers 6 and 7, but also Schmitt trigger type comparators 12 and 13, latch circuits 8 and 9, and the like. An external magnetic field detection signal is taken out from external output terminals 10 and 11.

If the external magnetic field in the positive direction acts on the magnetic detection device shown in Fig. 17, then the resistance of the first magneto-resistance effect elements 2 forming the first bridge circuit BC1 is varied. As the result, an output is differential amplified in the first differential amplifier 6, and the detection signal caused by the amplified output is generated, then the detection signal is outputted from the first external output terminal 10. On the other hand, if the external magnetic field in the negative direction acts on the magnetic detection device, then the resistance of the second magneto-resistance effect elements 3 forming the second bridge circuit BC2 is varied. As the result, an output is differential amplified in the second differential amplifier 7, and the detection signal caused by the amplified output is generated, then the detection signal is outputted from the second external output terminal 11.

As mentioned above, the magnetic detection device shown in Fig. 17 is the NS detection type sensor that can detect the external magnetic fields in both of the positive and negative directions.

In a magnetic sensor according to JP H08 160 114 A magneto-resistant (MR) elements are arranged so that their magnetic field detecting directions can intersect each other at a right angle and an operational amplifier circuit outputs a potential difference generated by the variation of the resistance values of the elements. Since the resistance values of resistors are set at the same value, the resistors operate as a current mirror circuit. When a magnetic field is impressed upon a magnetic sensor, a potential difference is generated between the collector-side potentials of transistors, because the resistance value of one of the MR elements drops. The position of an object is detected based on the potential difference. In addition, since the resistance values of the resistors are set at larger values than those of the MR elements, the current consumption of the sensor varies depending upon the resistance values of the resistors. Therefore, the pattern areas of the MR elements can be reduced, because the resistance values of the MR elements are not required to be increased for reducing the current consumption.

According to US 2005 200 449 A1 a magnetic sensor includes eight SAF-type GMR elements. Four of the GMR elements detect a magnetic field in the direction of the X-axis and are bridge-connected to thereby constitute an X-axis magnetic sensor. The other four GMR elements detect a magnetic field in the direction of the Y-axis and are bridge-connected to thereby constitute a Y-axis magnetic sensor. The magnetization of a pinned layer of each of the GMR elements is pinned in a fixed direction by means of a magnetic field that a permanent bar magnet inserted into a square portion of a yoke of a magnet array generates in the vicinity of a rectangular portion of the yoke. A magnetic field generated in the vicinity of a certain rectangular portion of the yoke differs in direction by 90 degrees from a magnetic field generated in the vicinity of a rectangular portion adjacent to the former rectangular portion.
Patent Document 1: Japanese Unexamined Patent Application Publication No. 2004-77374
Patent Document 2: Japanese Unexamined Patent Application Publication No. 2004-180286
Patent Document 3: Japanese Unexamined Patent Application Publication No. 2005-214900
Patent Document 4: Japanese Unexamined Patent Application Publication No. 2003-14833
Patent Document 5: Japanese Unexamined Patent Application Publication No. 2003-14834
Patent Document 6: Japanese Unexamined Patent Application Publication No. 2003-121268
Patent Document 7: Japanese Unexamined Patent Application Publication No. 2004-304052

### Disclosure of Invention

### Problems to be Solved by the Invention

However, the known magnetic detection device shown in Fig. 17 needs a lot of elements to form the sensor unit S. Specifically, to configure the NS detection type sensor, two bridge circuits BC1 and BC2 are needed, consequently, totally eight elements are needed.

Since the magnetic detection device includes two bridge circuits BC1 and BC2, for the bridge circuit BC1 and BC2, the differential amplifiers 6 and 7, the comparators 12 and 13, signal lines and the like are to be provided respectively, and the circuit configuration is complicated. Further, it is difficult to reduce the size of the integrated circuit 1.

The present invention is contrived to solve the aforementioned problems, and particularly, an object is to provide a magnetic detection device of an NS detection type capable of simplifying a circuit configuration in accompany with decrease in the number of elements.

### Means for Solving the Problems

A magnetic detection device according to the invention includes a first series circuit, a second series circuit, and a third series circuit. At least one of a plurality of resistance elements forming the first series circuit includes a first magneto-resistance effect element using a magneto-resistance effect, of which an electric resistance varies with an external magnetic field of one direction. At least one of a plurality of resistance elements forming the second series circuit includes a second magneto-resistance effect element using a second magneto-resistance effect, of which an electric resistance varies with an external magnetic field of a direction opposite to the one direction. A plurality of resistance elements forming the third series circuit is common resistance elements connected to the resistance elements of the first series circuit and the resistance elements of the second series circuit in a bridge manner respectively. A first output extracting portion of the first series circuit and a second output extracting portion of the second series circuit are individually connected to a common differential output portion through a first connection switch portion and a third output extracting portion of the third series circuit is connected to the common differential output portion. A first bridge circuit for detecting the external magnetic field of the one direction including the first series circuit and the third series circuit connected in parallel to each other is switched to a connection state with the differential output portion when the first output extracting portion is connected to the differential output portion by the first connection switch portion, and a second bridge circuit for detecting the external magnetic field of the opposite direction including the second series circuit and the third series circuit connected in parallel to each other is switched to a connection state with the differential output portion when the second output extracting portion is connected to the differential output portion by the first connection switch portion.

In the present invention, in the NS detection type magnetic detection device, the number of elements can be reduced and the circuit configuration can be simplified as compared to the known device. That is, in the present invention, the third series circuit is commonly used by the first bridge circuit and the second bridge circuit. Accordingly, as compared to the known device, the number of elements necessary to form the two bridges can be reduced. Further, in the present invention, the first connection switch portion is provided to switch over the connection between the first output extracting portion or the second output extracting portion and the differential output portion. Accordingly, it is possible to obtain the two states that the first bridge circuit is connected to the differential output portion and the second bridge circuit is connected to the differential output portion with the simple circuit configuration.

In the present invention, it is preferable that a first resistance element and a second resistance element of the first series circuit are connected in series through the first output extracting portion, and the first resistance element is formed of the first magneto-resistance effect element, a third resistance element and a fourth resistance element of the second series circuit are connected in series through the second output extracting portion, and the third resistance element is formed of the second magneto-resistance effect element, a fifth resistance element and a sixth resistance element of the third series circuit are connected in series through the third output extracting portion, the first resistance element is connected in parallel to the sixth resistance element and the second resistance element is connected in parallel to the fifth resistance element, thereby forming the first bridge circuit, and the third resistance element is connected in parallel to the fifth resistance element and the fourth resistance element is connected in parallel to the sixth resistance element, thereby forming the second bridge circuit.

In the present invention, it is preferable that the magnetic detection device includes a first external output terminal, a second external output terminal, and a second connection switch portion for switching over a connection between the differential output portion and the first external output terminal and a connection between the differential output portion and the second external output terminal. The differential output portion and the first external output terminal are connected to each other by the second connection switch portion when the first output extracting portion and the differential output portion are connected to each other by the first connection switch portion, and the differential output portion and the second external output terminal are connected to each other by the second connection switch portion when the second output extracting portion and the differential output portion are connected to each other by the first connection switch portion.

In the present invention, with the simple circuit configuration, the two-output NS detection type sensor that can also detect an external magnetic field direction can be obtained.

In the present invention, it is preferable that the magnetic detection device includes a third connection switch portion for switching over a connection between at least one of an input terminal and an earth terminal and the first series circuit, and a connection between the one terminal and the second series circuit. The first series circuit and the one terminal are connected to each other by the third connection switch portion when the first output extracting portion and the differential output portion are connected to each other by the first connection switch portion, and the second series circuit and the one terminal are connected to each other by the third connection switch portion when the second output extracting portion and the differential output portion are connected to each other by the first connection switch portion. By the magnetic detection device, between the first series circuit and the second series circuit, an electric current is not supplied to the circuit that is not connected to the differential output portion. Accordingly, the consumption current can be reduced and the detection sensitivity can be increased.

### Advantages

In the present invention, in the NS detection type magnetic detection device, the number of elements can be reduced as compared to the known device, and the circuit configuration can be simplified. Further, the consumption current can be reduced.

### Best Mode for Carrying Out the Invention

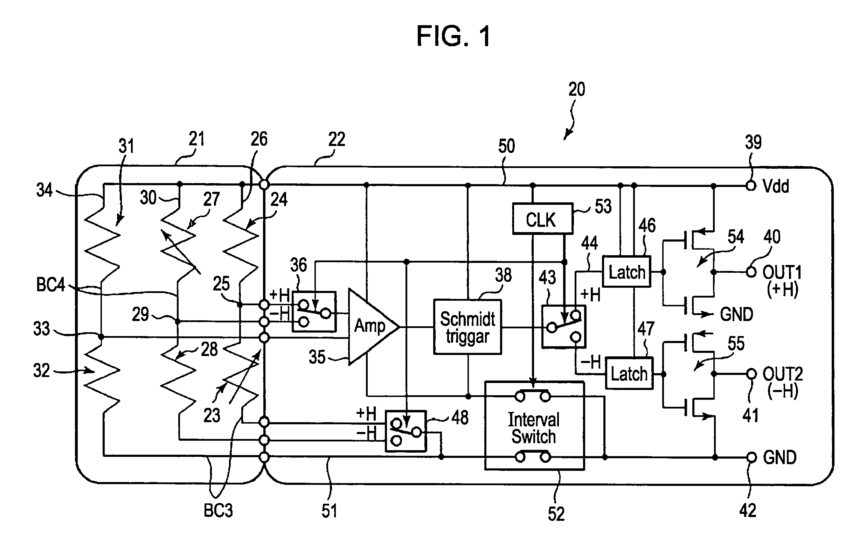

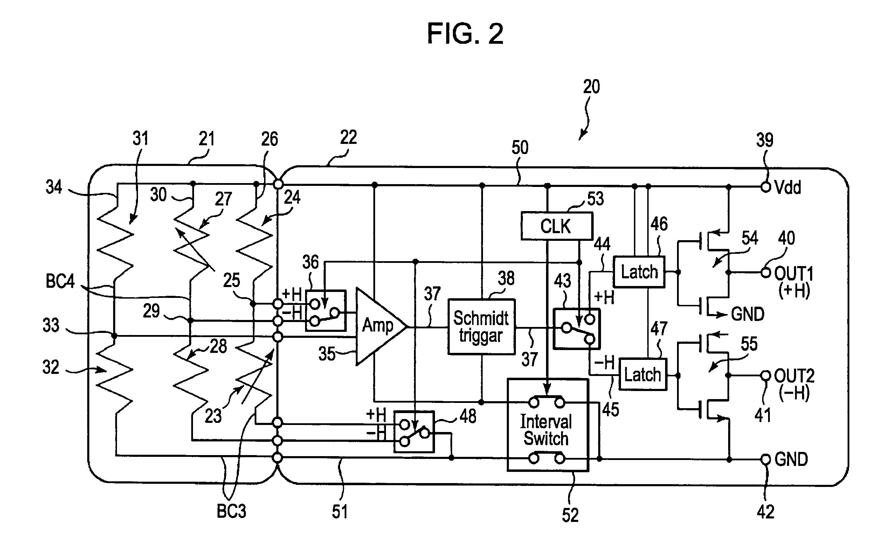

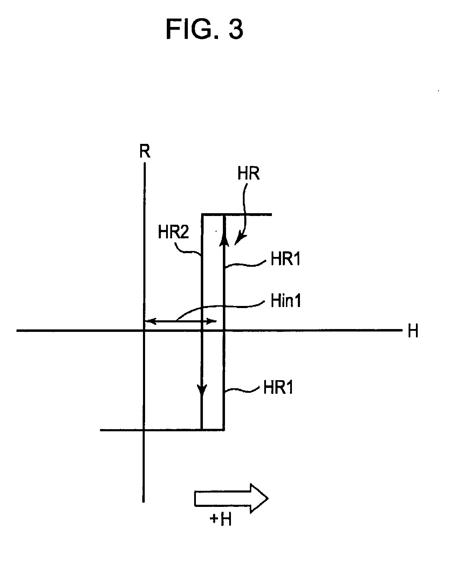

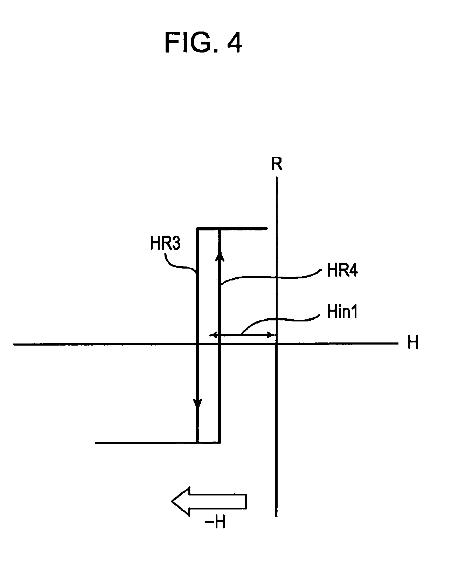

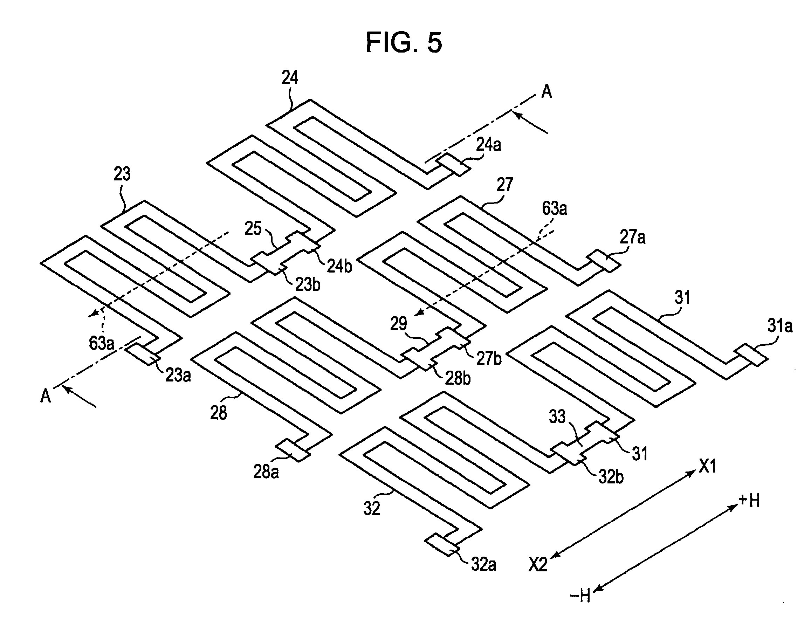

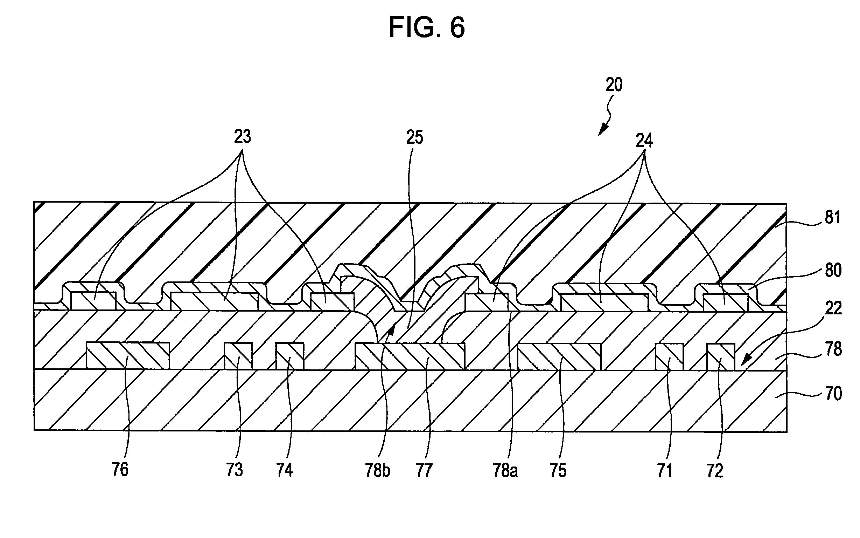

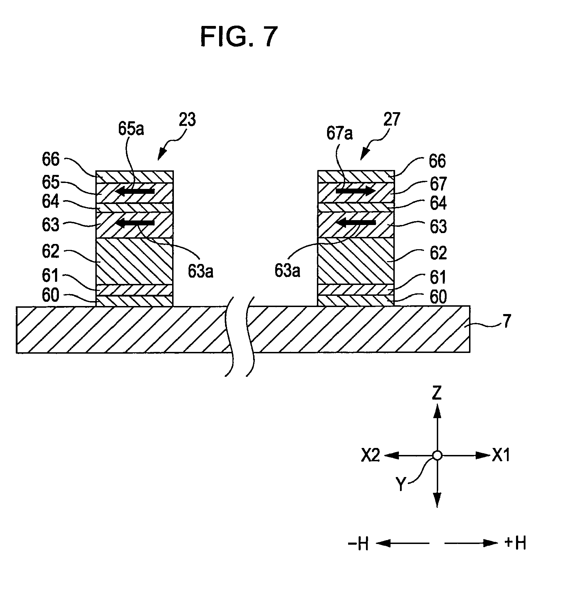

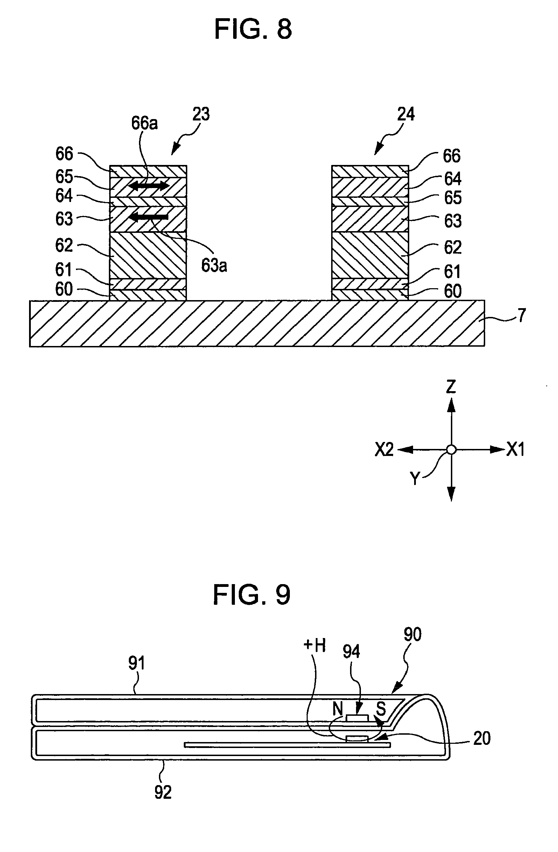

Figs. 1 and 2 are circuit diagrams of a magnetic detection device 20 according to an embodiment. Fig. 3 is a graph (curve R-H) to illustrate a hysteresis characteristic of a first magneto-resistance effect element. Fig. 4 is a graph (curve R-H) to illustrate a hysteresis characteristic of a second magneto-resistance effect element. Fig. 5 is a partially enlarged perspective view of the magnetic detection device 20 illustrating a shape of a resistance element of a sensor unit of the magnetic detection device 20 according to the embodiment. Fig. 6 is a partially sectional view of the magnetic detection device taken along Line A-A of Fig. 5 in a thickness direction as viewed in the direction of an arrow. Fig. 7 is a partially sectional view illustrating layer structures of the first magneto-resistance effect element and the second magneto-resistance effect element. Fig. 8 is a partially sectional view mainly illustrating a layer structure of a fixed resistance element. Figs. 9 to 16 are examples illustrating the use of the magnetic detection device according to the embodiment, and partially schematic views or partially plan views of a foldable cellular phone having the magnetic detection device.

The magnetic detection device 20 illustrated in Fig. 1 includes a sensor unit 21 and an integrated circuit (IC) 22.

The sensor unit 21 includes a first series circuit 26 of which a first resistance element (a first magneto-resistance effect element) 23 is series connected to a second resistance element (a fixed resistance element in the embodiment) 24 through a first output extracting portion(a connection portion) 25, a second series circuit 30 of which a third resistance element (a second magneto-resistance effect element) 27 is series connected to a fourth resistance element (a fixed resistance element in the embodiment) 28 through a second output extracting portion(a connection portion) 29, and a third series circuit 34 of which a fifth resistance element (a fixed resistance element in the embodiment) 31 is series connected to a sixth resistance element (a fixed resistance element in the embodiment) 32 through a third output extracting portion 33.

As mentioned above, "the resistance element" is expressed in a serial number which is from the first to the sixth. Hereinafter, each resistance element is mainly expressed as "magneto-resistance effect element" and "fixed resistance element". When it is not necessary to distinguish between "magneto-resistance effect element" and "fixed resistance element", an expression of "resistance element" will be used.

The third series circuit 34 is a common circuit, thereby forming bridge circuits with the first series circuit 26 and the second series circuit 30 respectively. Hereinafter, a bridge circuit formed by connecting the first series circuit 26 to the third series circuit 34 in parallel will be referred to as a first bridge circuit BC3 and the bridge circuit formed by connecting the second series circuit 30 to the third series circuit 34 in parallel will be referred to as a second bridge circuit BC4.

As shown in Fig. 1, in the first bridge circuit BC3, the first resistance element 23 is connected to the sixth resistance element 32 in parallel, and the second resistance element 24 is connected to the fifth resistance element 31 in parallel. In the second bridge circuit BC4, the third resistance element 27 is connected to the fifth resistance element 31 in parallel, and the fourth resistance element 28 is connected to the sixth resistance element 32 in parallel.

As shown in Fig. 1, the integrated circuit 22 includes an input portion (power) 39, an earth terminal 42, and two of external output terminals 40 and 41. The input terminal 39, the earth terminal 42, and the external output terminals 40 and 41 are electrically connected to terminals of another device not shown in the drawings respectively by a wire bonding method or a die bonding method.

A signal line 50 connected to the input terminal 39 and a signal line 51 connected to the earth terminal 42 are connected to electrodes prepared on ends of the both sides of the first series circuit 26, the second series circuit 30, and the third series circuit 34 respectively.

As shown in Fig. 1, the integrated circuit 22 includes one differential amplifier (differential output portion) 35. One of a + input portion and a - input portion of the differential amplifier 35 is connected to the third output extracting portion 33 of the third series circuit 34. The connection between the third output extracting portion 33 and the differential amplifier 35 is described below. The connection between the third output extracting portion 33 and the differential amplifier 35 is differently fixed from connection states between the first output extracting portion 25 of the first series circuit 26 and the second output extracting portion 29 of the second series circuit 30 and the differential amplifier 35 (there is no case as non connection state).

The first output extracting portion 25 of the first series circuit 26 and the second output extracting portion 29 of the second series circuit 30 are connected to the input portions of the first switch circuit (a first connection switch portion) 36 respectively. The output portion of the first switch circuit 36 is connected to one of the - input portion and the + input portion (the input portion of which the third output extracting portion 33 is not connected) of the differential amplifier 35.

As shown in Fig. 1, the output portion of the differential amplifier 35 is connected to a Schmitt trigger-type comparator 38. The output portion of the comparator 38 is connected to the input portion of the second switch circuit (the second connection switch portion) 43. The output portion side of the second switch circuit 43 is connected to a first external output terminal 40 and a second external output terminal 41 through two of latch circuits 46 and 47, FET circuits 54 and 55 respectively.

As shown in Fig. 1, the integrated circuit 22 includes a third switch circuit 48. An output portion of the third switch circuit 48 is connected to the signal line 51 connected to the earth terminal 42. To input portions of the third switch circuit 48, one end of the first series circuit 26 and the second series circuit 30 is connected.

As shown in Fig. 1, the integrated circuit 22 includes an interval switch circuit 52 and a clock circuit 53. When a switch of the interval switch circuit 52 is turned off, power supply to the integrated circuit 22 is stopped. On and Off of the switch of the interval switch circuit 52 is interlocked with a clock signal from the clock circuit 53 and the interval switch circuit 52 has an electric power saving function which intermittently electrifies.

The clock signal out of the clock circuit 53 is outputted to the first switch circuit 36, the second switch circuit 43, and the third switch circuit 48 respectively. When the clock signal is received in the first switch circuit 36, the second switch circuit 43, and the third switch circuit 48, the clock signal is distributed to perform the operation of the switch at very short interval, thereby controlling the operation of the switch. For example, when one pulse duration of clock signal is in several tens of msec, the switch operates every several tens of µmsec.

The first magneto-resistance effect element 23 is a magneto-resistance effect element which shows a magneto-resistance effect on the basis of an intensity variation in external magnetic field magnitude in a positive direction (+H) and the second magneto-resistance effect element 27 is a magneto-resistance effect element which shows a magneto-resistance effect on the basis of the intensity variation in external magnetic field magnitude in a negative direction (-H) which is opposite to the positive direction.

Here, the external magnetic field in the positive direction (+H) indicates a direction, in the embodiment, the direction toward the X1 direction in the drawings. When the external magnetic field of the direction acts, as described in Fig. 3 and Fig. 4, the resistance of the first magneto-resistance effect element 23 is varied, however the resistance of the second magneto-resistance effect element 27 is not varied (that is, functions as fixed resistance element).

Otherwise, the external magnetic field in the negative direction (-H) is an external magnetic field in an opposite direction to the positive direction, and the direction toward the X2 direction in the drawings. When the external magnetic field of the direction acts, as described in Fig. 3 and Fig. 4, the resistance of the second magneto-resistance effect element 27 is varied, however the resistance of the first magneto-resistance effect element 23 is not varied (that is, functions as fixed resistance element).

Hereinafter, layer structures and hysteresis characteristics of the first magneto-resistance effect element 23 and the second magneto-resistance effect element 27 will be described in detail.

As shown in Fig. 7, the first magneto-resistance effect element 23 and the second magneto-resistance effect element 27 have layers which are sequentially laminated from the bottom of an underlying layer 60, a seed layer 61, an antiferromagnetic layer 62, a fixed magnetic layer 63, a non-magnetic intermediate layer 64, free magnetic layers 65 and 67 (the free magnetic layer of the second magneto-resistance effect element 27 is shown by a reference numeral 37), and a protection layer 66. The underlying layer 60 is formed of a non-magnetic material at least one element of such as Ta, Hf, Nb, Zr, Ti, Mo, W. The seed layer 61 is formed of NiFeCr or Cr, or the like. The antiferromagnetic layer 62 is formed of an antiferromagnetic material containing element α (herein, α is at least one element of Pt, Pd, Ir, Rh, Ru, Os) and Mn, or an antiferromagnetic material containing element α and element α' (herein, element α' is at least one element of Ne, Ar, Kr, Xe, Be, B, C, N, Mg, Al, Si, P, Ti, V, Cr, Fe, Co, Ni, Cu, Zn, Ga, Ge, Zr, Nb, Mo, Ag, Cd, Sn, Hf, Ta, W, Re, Au, Pb, and rare-earth elements) and Mn. For example, the antiferromagnetic layer 62 is formed of IrMn or PtMn. The fixed magnetic layer 63 and the free magnetic layers 65 and 67 are formed of a magnetic material such as CoFe alloy, NiFe alloy, CoFeNi alloy or the like. The non-magnetic intermediate layer 64 is formed of Cu or the like. The protection layer 66 is formed of Ta or the like. The fixed magnetic layer 63, the free magnetic layers 65 and 67 may have lamination layer ferri structures (The lamination structure has a sequential laminated order of the magnetic layer, the non-magnetic layer, and the magnetic layer. The non-magnetic layer is interposed between two of the magnetic layers which have anti-parallel magnetization directions). Further, the fixed magnetic layer 63, the free magnetic layers 65 and 67 may have a lamination structure of which a plurality of magnetic layers made of different materials is laminated.

In the first magneto-resistance effect element 23 and the second magneto-resistance effect element 27, the antiferromagnetic layer 62 is formed in contact with the fixed magnetic layer 63, whereby an exchanging coupling magnetic field (Hex) is made on an interface between the antiferromagnetic layer 62 and the fixed magnetic layer 63 by a heat treatment in a magnetic field, thereby fixing the magnetization direction of the fixed magnetic layer 63 to one direction. Figs. 5 and 7 indicate a magnetization direction 63a of the fixed magnetic layer 63 as an arrow direction. In the first magneto-resistance effect element 23 and the second magneto-resistance effect element 27, both of the magnetization directions 63a of the fixed magnetic layers 63 are the shown X1 directions (i.e. the positive directions).

Meanwhile, the magnetization directions of the free magnetic layers 65 and 67 are different between the first magneto-resistance effect element 23 and the second magneto-resistance effect element 27. As shown in Fig. 7, in the first magneto-resistance effect element 23, a magnetization direction 65a of the free magnetic layer 65 is the shown X2 direction (i.e. the negative direction), which is in the same as the magnetization direction 63a of the fixed magnetic layer 63, but in the second magneto-resistance effect element 27, the magnetization direction 67a of the free magnetic layer 67 is the shown X1 direction (the positive direction), which is in an anti-parallel direction to the magnetization direction 63a of the fixed magnetic layer 63.

When the external magnetic field in the positive direction (+H) acts, the magnetization 67a of the free magnetic layer 67 of the second magneto-resistance effect element 27 is not varied, but the magnetization 65a of the free magnetic layer 65 of the first magneto-resistance effect element 23 varies with the consequence that the resistance of the first magneto-resistance effect element 23 varies. Fig. 3 is the curve R-H illustrating the hysteresis characteristic of the first magneto-resistance effect element 23. In Fig. 3, the vertical axis is the resistance R, but it may be a variation rate of the resistance (%). As shown in Fig. 3, when the external magnetic field is gradually increased from a non-magnetic field (zero) to the positive direction, a parallel state between the magnetization 65a of the free magnetic layer 65 and the magnetization 63a of the fixed magnetic layer 63 is given away with the consequence that it becomes close to an anti-parallel state, whereby the resistance R of the first magneto-resistance effect element 23 gradually becomes large taking along the curve HR1. When the external magnetic field in the positive direction (+H) is gradually decreased to the zero, the resistance R of the first magneto-resistance effect element 23 is gradually decreased taking along the curve HR2.

As described above, in the first magneto-resistance effect element 23, a hysteresis loop HR surrounded by the curves HR1 and HR2 is formed according to the variation in magnetic field magnitude of the external magnetic field in the positive direction (+H). A central value between a maximum resistance and a minimum resistance of the first magneto-resistance effect element 23, and a central value of a width of the hysteresis loop HR is a middle point of the hysteresis loop HR. The magnitude of a first inter-layer coupling magnetic field Hin1 is determined by the magnitude of the magnetic field in the range of the center point of the hysteresis loop HR to the external magnetic field line H=0(Oe). As shown in Fig. 3, in the first magneto-resistance effect element 23, the first inter-layer coupling magnetic field Hin1 is shifted toward the magnetic field in the positive direction.

Meanwhile, when the external magnetic field in the negative direction (-H) acts, the magnetization 65a of the free magnetic layer 65 of the first magneto-resistance effect element 23 does not vary, but the magnetization 67a of the free magnetic layer 67 of the second magneto-resistance effect element 27 varies with the consequence that the resistance of the second magneto-resistance effect element 27 varies.

Fig. 4 is the curve R-H illustrating the hysteresis characteristic of the second magneto-resistance effect element 27. As shown in Fig. 4, when the external magnetic field is gradually increased from the non-magnetic field state (zero) to the negative direction, the anti-parallel state between the magnetization 67a of the free magnetic layer 67 and the magnetization 63a of the fixed magnetic layer 63 is given away to become close to a parallel state. Consequently, the resistance R of the second magneto-resistance effect element 27 is gradually decreased taking along the curve HR3. Meanwhile, when the external magnetic field in the negative direction (-H) is changed toward zero, the resistance R of the second magneto-resistance effect element 27 is gradually increased taking along the curve HR4.

As described above, in the second magneto-resistance effect element 27, a hysteresis loop HR surrounded by the curves HR3 and HR4 is formed according to the variation in the magnetic field magnitude of the external magnetic field in the negative direction (-H). A middle point of the hysteresis loop HR is a central value between a maximum resistance and a minimum resistance of the second magneto-resistance effect element 27 and also a central value of a width of the hysteresis loop HR. The magnitude of the second inter-layer coupling magnetic field Hin2 is determined by the magnitude of the magnetic field in the range of the center point of the hysteresis loop HR to the external magnetic field line H=0 (Oe). As shown in Fig. 4, in the second magneto-resistance effect element 27, the second inter-layer coupling magnetic field Hin2 is shifted toward the magnetic field in the negative direction.

As described above, in the embodiment, the first inter-layer coupling magnetic field Hin1 of the first magneto-resistance effect element 23 is shifted to the magnetic field in the positive direction. Meanwhile, the second inter-layer coupling magnetic field Hin2 of the second magneto-resistance effect element 27 is shifted to the magnetic field in the negative direction.

The inter-layer coupling magnetic fields Hin1 and Hin2, which have opposite magnetic field directions illustrated in Figs. 3 and 4 can be obtained, for example, by adequately adjusting a gas flow (a gas pressure) or a voltage at the time of performing a plasma treatment (PT) on the surface of the non-magnetic intermediate layer 64. It has been known that according to the level of the gas flow (the gas pressure) or the voltage, the inter-layer coupling magnetic field Hin is changed. When the level of the gas flow (the gas pressure) or the voltage is increased, the inter-layer coupling magnetic field Hin can be changed from a negative value to a positive value. In addition, the magnitude of the inter-layer coupling magnetic field Hin changes by the thickness of the non-magnetic intermediate layer 64. The magnitude of the inter-layer coupling magnetic field Hin can be adjusted by changing the thickness of the film of the antiferromagnetic layer when it is sequentially laminated from the bottom of the antiferromagnetic layer, the fixed magnetic layer, the non-magnetic intermediate layer, and the free magnetic layer.

In the first magneto-resistance effect element 23, the first inter-layer coupling magnetic field Hin1 has the positive value with the consequence that an interaction of the magnetization to be parallel acts between the fixed magnetic layer 63 and the free magnetic layer 65. In the second magneto-resistance effect element 27, the second inter-layer coupling magnetic field Hin2 has the negative value with the consequence that an interaction of the magnetization to be anti-parallel acts between the fixed magnetic layer 63 and the free magnetic layer 67. An exchanging coupling magnetic field (Hex) in the same direction between the antiferromagnetic layer 62 and the fixed magnetic layer 63 of each of the magneto-resistance effect elements 23 and 27 is made by the heat treatment in the magnetic field, whereby the magnetization 63a of the fixed magnetic layer 63 of each of the magneto-resistance effect elements 23 and 27 can be fixed in the same direction. Further, the above mentioned interaction acts between the fixed magnetic layer 63 and the free magnetic layers 65 and 67 to be the state of magnetic field as shown in Fig. 7.

The first magneto-resistance effect element 23 and the second magneto-resistance effect element 27 use the giant magneto-resistance effect (GMR effect). However, an AMR element using an anisotropic magneto-resistance effect (AMR) and a TMR element using a tunnel magneto-resistance effect (TMR) except for a GMR element may be used.

Meanwhile, the fixed resistance element 24 which is connected to the first magneto-resistance effect element 23 in series has a different lamination order from the first magneto-resistance effect element 23, which is formed of the same material layers as the first magneto-resistance effect element 23. Namely, as shown in Fig. 8, the fixed resistance element 24 is sequentially laminated from the bottom of the underlying layer 60, the seed layer 61, the antiferromagnetic layer 62, the first magnetic layer 63, the second magnetic layer 65, the non-magnetic intermediate layer 64, and the protection layer 66. The first magnetic layer 63 is corresponded to the fixed magnetic layer 63 included in the first magneto-resistance effect element 23. The second magnetic layer 65 is corresponded to the free magnetic layer 65 included in the first magneto-resistance effect element 23. As shown in Fig. 8, in the first fixed resistance element 23, the first magnetic layer 63 and the second magnetic layer 65 are sequentially laminated on the antiferromagnetic layer 62, whereby the magnetizations of the first magnetic layer 63 and the second magnetic layer 65 are fixed by the exchanging coupling magnetic field (Hex) which is generated between antiferromagnetic layer 62. The magnetization of the second magnetic layer 65 does not vary due to the external magnetic field, different from the free magnetic layer 65 of the first magneto-resistance effect element 23.

As shown in Fig. 8, when each layer of the fixed resistance element 24 is formed of the same material as the corresponding layer of the first magneto-resistance effect element 23, the element resistance of the first magneto-resistance effect element 23 and the fixed resistance element 24 can be almost the same. The variation of the temperature coefficients (TCR) of the first magneto-resistance effect element 23 and the fixed resistance element 23 can be suppressed, thereby improving an operational stability because the variation of the central potential according to a temperature variation can be suppressed. Additionally, it is more preferable that not only the material, but also the thickness of each layer corresponding to the first magneto-resistance effect element 23 be the same as that of the first magneto-resistance effect element 23.

Although not shown in the drawings, the fixed resistance element 28 which is connected to the second magneto-resistance effect element 27 in series has a different lamination order from the second magneto-resistance effect element 27, but similarly to the above, has the same material layers as the second magneto-resistance effect element 27.

Additionally, the fixed resistance elements 31 and 32 constituting the third series circuit 34 have no limitation in the layer structures in particular when the element resistances forming the same material layers have almost the same values. Specifically, each of the fixed resistance elements 31 and 32 can be formed of a single layer including a resistance material such as a material having high sheet resistance. However it is preferable that a production process be simplified by the process forming the fixed resistance elements 24 and 28 constituting the first series circuit 26 and the second series circuit 30 with forming the fixed resistance elements 31 and 32 simultaneously. Therefore, similarly to the fixed resistance elements 24 and 28 of the first series circuit 26 and the second series circuit 30, it is preferable that the fixed resistance elements 31 and 32 be formed of the same material layers as the first magneto-resistance effect element 23 or the second magneto-resistance effect element 27 with the lamination order different from the first magneto-resistance effect element 23 or the second magneto-resistance effect element 27.

Now, a detection theory of the external magnetic field will be described.

First, it will be described in case that an external magnetic field is not acting on the magnetic detection device 20 in this embodiment. In such a case, both resistance of the first magneto-resistance effect element 23 and the second magneto-resistance effect element 27 are not varied. When a clock signal from the clock circuit 53 is respectively sent to the first switch circuit 36, the second switch circuit 43 and the third switch circuit 48, there is switched over at intervals of several tens of micro seconds, as shown in Fig. 1, in condition of the positive directional external magnetic field (+H) detection circuit in which the first switch circuit 36 connects between the first output extracting portion 25 of the first series circuit 26 and the differential amplifier 35, the second switch circuit 43 connects between the comparator 38 and the first external output terminal 40, and the third switch circuit 48 connects between the first series circuit 26 and the earth terminal 42, and as shown in Fig. 2, in condition of the negative directional external magnetic field (-H) detection circuit in which the first switch circuit 36 connects between the second output extracting portion 29 of the second series circuit 30 and the differential amplifier 35, the second switch circuit 43 connects between the comparator 38 and the second external output terminal 41, and the third switch circuit 48 connects between the second series circuit 30 and the earth terminal 42.

When the external magnetic field is not reached to the magnetic detection device, in the condition of the positive directional external magnetic field (+H) detection circuit in Fig. 1, the differential potential between the first output extracting portion 25 and the third output extracting portion 33 of the first bridge circuit BC3 becomes almost zero, and in the condition of the negative directional external magnetic field (-H) detection circuit in Fig. 2, the differential potential between the second output extracting portion 29 and the third output extracting portion 33 of the second bridge circuit BC4 also becomes almost zero. When the output having the differential potential of zero is outputted to the comparator 38 from the differential amplifier 35, the comparator 38 is controlled, for example, such that by a Schmitt trigger input, a high level signal is outputted from the first external output terminal 40 and the second external output terminal 41 through the latch circuits 46 and 47, and the FET circuit 54.

In the next, if the external magnetic field in the positive direction (+H) acts on the magnetic detection device 20 of the embodiment, the resistance of the first magneto-resistance effect element 23 is varied. As the result, the central potential in the first output extracting portion 25 of the first series circuit 26 is also varied. (If the circuit configuration in Fig. 1 has the hysteresis characteristics in Fig. 3, specifically the potential is increased.)

In this external magnetic field detection circuit condition in the positive direction (+H) shown in Fig. 1, the central potential of the third output extracting portion 33 in the third series circuit 34 is set to a reference potential, and the differential potential between the first output extracting portion 25 and the third output extracting portion 33 of the first bridge circuit BC3 formed of the first series circuit 26 and the third series circuit 34 is generated in the differential amplifier 35, and outputted to the comparator 38. The comparator 38 varies the differential potential to shape into a pulse signal by the Schmitt trigger input, and the shaped detection pulse signal is outputted from the first external output terminal 40 through the latch circuit 46 and the FET circuit 54. In this case, if the magnitude of external magnetic field in the positive direction (+H) is a predetermined magnitude or more, the detection signal is controlled to be outputted as a low level signal from the first external output terminal 40. If the magnitude of the external magnetic field in the positive direction (+H) is smaller than a predetermined magnitude, the comparator 38 is controlled to generate a high level signal, and there is no difference as compared with the case that the external magnetic field is not acting.

Contrarily, when the external magnetic field of the positive direction (+H) is acting, even the magnetic detection device is switched over in state of the external magnetic field (-H) detection circuit of the negative direction in Fig. 2, the resistance of the second magneto-resistance effect element 27 is not varied. Therefore, similarly to the case where the external magnetic field is not acting, it is controlled such that the high level signal is outputted from the second external output terminal 41.

As described above, at the first external output terminal 40, when the external magnetic field in the positive direction (+H) of the predetermined magnitude or more acts, the signal level is changed from the high level to the low level (or, the opposite case is possible). Accordingly, by the change of the signal level, it is possible to detect whether the positive directional external magnetic field (+H) of the predetermined magnitude or more is acting.

Similarly to the above, when the external magnetic field in the negative direction (-H) acts on the magnetic detection device 20 of the embodiment, the resistance of the second magneto-resistance effect element 23 is varied. As the result, the central potential in the second output extracting portion 29 of the second series circuit 30 is varied. (If the circuit configuration in Fig. 1 has the hysteresis characteristics in Fig. 4, specifically the potential is increased.

In this external magnetic field (-H) detection circuit condition in the negative direction shown in Fig. 2, the central potential of the third output extracting portion 33 in the third series circuit 34 is set to a reference potential, and the differential potential between the second output extracting portion 29 and the third output extracting portion 33 of the second bridge circuit BC4 formed of the second series circuit 30 and the third series circuit 34 is generated in the differential amplifier 35, and outputted to the comparator 38. The comparator 38 varies the differential potential to shape into a pulse signal by the Schmitt trigger input, and the shaped detection pulse signal is outputted from the second external output terminal 41 through the latch circuit 46 and the FET circuit 54. In this case, if the magnitude of external magnetic field in the negative direction (-H) is a predetermined magnitude or more, it is controlled such that the detection signal is outputted as a low level signal from the second external output terminal 41. When the magnitude of the external magnetic field (-H) in the negative direction is smaller than a predetermined magnitude, the comparator 38 is controlled to generate a high level signal, and there is no difference as compared with the case that the external magnetic field is not acting.

Contrarily, when the external magnetic field of the negative direction (-H) is acting, even the magnetic detection device is switched over to the state of the external magnetic field (+H) detection circuit of the positive direction in Fig. 1, the resistance of the first magneto-resistance effect element 23 is not varied. Therefore, similarly to the case where the external magnetic field is not acting, it is controlled such that the high level signal is outputted from the first external output terminal 40.

As described above, at the second external output terminal 41, when the external magnetic field in the negative direction (-H) of the predetermined magnitude or more acts, the signal level is changed from the high level to the low level (or, the opposite case is possible). Accordingly, by the change of the signal level, it is possible to detect whether the negative directional external magnetic field of the predetermined magnitude or more is acting.

If the magnitude of the external magnetic field in the negative direction (-H) is smaller than a predetermined magnitude, in the comparator 38, a high level signal is generated, and there is no difference as compared with the case that the external magnetic field is not acting.

The detection signal outputted from the first external output terminal 40 or the second external output terminal 41 is used in a signal processing circuit and the like of another device part that is not illustrated, for example, as a detection signal for opening and closing of a foldable cellular phone mentioned below.

Now, a cross-sectional shape of the magnetic detection device 20 according to embodiment will be described with reference to Fig. 6. As shown in Fig. 6, in the magnetic detection device 20, an underlying film of a predetermined thickness made of silica (SiO₂) not shown in the drawings is formed on a substrate 70 formed of, for example, silicon (Si).

On the underlying film, active elements 71 to 74 such as a differential amplifier, a comparator, resistance elements 75 and 76, an interconnection layer (signal line) 77, and the like that constitute the integrated circuit 22 are formed. The interconnection layer 77 is formed of, for example, aluminum (A1).

As shown in Fig. 6, front surfaces of the substrate 70 and the integrated circuit 22 are covered by an insulating layer 78 formed of a resistance element layer and the like. In the insulating layer 78, a through hole 78b is formed on a certain part of the interconnection layer 77 and the front surface of the interconnection layer 78 is exposed from the through hole 78b.

The front surface 78a of the insulating layer 78 is formed to be a flat surface. On the flat front surface 78a of the insulating layer 78, the first magneto-resistance effect element 23, the second magneto-resistance effect element 27, the fixed resistance elements 24, 28, 31 and 32 are formed in a meandering shape as shown in Fig. 5, whereby the element resistances of the individual elements can be increased and the consumption current can be decreased.

As shown in Fig. 5, electrodes 23a, 23b, 24a, 24b, 27a, 27b, 28a, 28b, 32a, 32b, 33a, and 33b are formed on both ends of each element. The electrode 23b of the first magneto-resistance effect element 23 is connected to the electrode 24b of the fixed resistance element 24 through the first output extracting portion 25. As shown in Fig. 6, the first output extracting portion 25 is electrically connected to the interconnection layer 77. Similarly, the electrode 27b of the second magneto-resistance effect element 27 is connected to the electrode 28b of the fixed resistance element 28 through the second output extracting portion 29 and the second output extracting portion 29 is electrically connected to an interconnection layer not shown in the drawings. The electrode 32b of the fixed resistance element 32 is connected to the electrode 31b of the fixed resistance element 31 through the third output extracting portion 33 and the third output extracting portion 33 is electrically connected to an interconnection layer not shown in the drawings.

As shown in Fig. 6, the front surfaces of the elements, the electrodes, and the output extracting portions are covered by an insulating layer 80 formed of, for example, alumina or silica. The magnetic detection device 20 is packaged by a mold resin 81.

Now, a special feature of the magnetic detection device 20 according to the embodiment will be described.

The magnetic detection device 20 is the NS detection magnetic sensor having the first bridge circuit BC3 to detect the external magnetic field of the positive direction (+H) and the second bridge circuit BC4 to detect the external magnetic field of the negative direction (-H).

In the embodiment, the central potential of the third series circuit 34 to which the fixed resistance elements 31 and 32 are connected in series is commonly used as the reference potential of the first bridge circuit BC3 and the second bridge circuit BC4. Further, the inside integrated circuit 22 is provided with the first switch circuit 36 that alternately switches over the connection between the first output extracting portion 25 of the first series circuit 26 forming the first bridge circuit BC3 and the differential amplifier 35, and the connection between the second output extracting portion 29 of the second series circuit 30 forming the second bridge circuit BC4 and the differential amplifier 35.

As mentioned above, the magnetic detection device 20 according to the embodiment is the NS detection magnetic sensor, however, using the third series circuit 34 as a common circuit in both of the first bridge circuit BC3 and the second bridge circuit BC4, the number of elements can be reduced since the required number of elements in the embodiment is totally 6 as illustrated in Fig. 1 and Fig. 2 in comparison that the total number of the required elements in the known NS detection type sensor using the magneto-resistance effect element is at least 8.

One of advantages in reducing the number of elements is that, other than the improvement of production efficiency, it is possible to form each element to have a larger space within the limited area for forming the elements. As shown in Fig. 5, each element is formed in the meander shape to increase the element resistance. Further, since each element can be formed to have a larger space than that of the known element, the length of each element may have a longer length than the length of the known element. As the result, the resistance of the elements may be appropriately increased.

Furthermore, in the embodiment, the third series circuit 34 is configured to be the common circuit of the first bridge circuit BC3 and the second bridge circuit BC4. Accordingly, by configuring the third output extracting portion 33 of the third series circuit 34 to be directly connected to one differential amplifier 35, and by using the first switch circuit 36 to switch over the connection between the first output extracting portion 25 of the first series circuit 26 and the differential amplifier 35, and the connection between the second output extracting portion 29 of the second series circuit 30 and the differential amplifier 35, by providing one differential amplifier 35, it is possible to alternately obtain the two detection conditions of the external magnetic field detection conditions of the positive direction the first bridge circuit BC3 is connected with the differential amplifier 35 (Fig. 1) and the negative direction the second bridge circuit BC4 is connected with the differential amplifier 35 (Fig. 2). As the result, the differential potentials in the differential amplifier 35 can be properly obtained from both of the first bridge circuit BC3 and the second bridge circuit BC4 with the simple circuit configuration.

According to the embodiment, the number of the signal lines can be reduced because just one comparator 38 is used, therefore the circuit configuration can be simplified, and the circuit can be decreased in size.

According to the aforementioned embodiment, in the NS type sensor, the number of elements can be reduced, and the circuit configuration can be simplified.

In addition, as shown in Fig. 1 and Fig. 2 in the embodiment, the magnetic detection device is provided with the second switch circuit 43 for switching over the connection between the differential amplifier 35 and the external output terminals 40 and 41. In the second switch circuit 43, the differential amplifier 35 and the first external output terminal 40 are connected to each other when the first output extracting portion 25 of the first bridge circuit BC3 and the differential amplifier 35 are connected to each other by the first switch circuit 36. In the second switch circuit 43, the differential amplifier 35 and the second external output terminal 41 are connected to each other, and by the first switch circuit 36 when the second output extracting portion 29 of the second bridge circuit BC4 and the differential amplifier 35 are connected to each other.

According to the embodiment, the two external output terminals 40 and 41 are provided, whereby the first switch circuit 36 and the second switch circuit 43 operate together. Therefore, the detection signal of the positive directional external magnetic field (+H) can be obtained from the first external output terminal 40, and the detection signal of the negative directional external magnetic field (-H) can be obtained from the second external output terminal 41. As the result, a direction of the external magnetic field can be detected according to whether the detection signal is from the first output terminal or the second output terminal by using the two outputs.

In addition, in the embodiment, the third switch circuit 48 to switch over the connection between the earth terminal 42 and the first series circuit 26, and the connection between the earth terminal 42 and the second series circuit 30 is provided.

When the first switch circuit 36 connects the first bridge circuit BC3 with the differential amplifier 35, the third switch circuit 48 connects the first series circuit 26 with the earth terminal 42. When the first switch circuit 36 connects the second bridge circuit BC4 with the differential amplifier 35, the third switch circuit 48 connects the second series circuit 30 with the earth terminal 42. In this circumstance, when the first bridge circuit BC3 is connected with the differential amplifier 35, no electric current is supplied into the second series circuit 30. When the second bridge circuit BC4 is connected with the differential amplifier 35, no electric current is supplied into the first series circuit 26. As the result, the consumption current can be reduced and the detection sensitivity can be increased.

The third switch circuit 48 may be provided between the input terminal 39 and the first series circuit 26, and between the input terminal 39 and the second series circuit 30 together with the earth terminal 42 side or instead of the earth terminal 42 side.

The magnetic detection device 20 of the NS detection type according to the embodiment may be used, for example, to detect opening or closing of a foldable cellular phone.

As shown in Fig. 9, a foldable cellular phone 90 includes a first member 91 and a second member 92. The first member 91 is a screen display portion, and the second member 92 is a manipulation portion. A facing surface of the first member 91 with the second member 92 is provided with a liquid crystal display, a receiver and the like. A facing surface of the second member 92 with the first member 91 is provided with various buttons, a microphone, and the like. Fig. 9 illustrates a folding state of the foldable cellular phone 90. As shown in Fig. 9, in the first member 91, a magnet 94 is provided, and in the second member 92, the magnetic detection device 20 according to the embodiment is provided. The magnet 94 and the magnetic detection device 20 are disposed at positions opposite to each other in the folding state shown in Fig. 9. Alternatively, the magnetic detection device 20 may be disposed at a position departing from the direction parallel to an application direction of the external magnetic field other than the position facing the magnet 94.

In Fig. 9, a positive directional external magnetic field (+H) emitted from the magnet 94 acts on the magnetic detection device 20, and the external magnetic field (+H) is detected in the magnetic detection device 20, whereby the folding state of the foldable cellular phone 90 is detected.

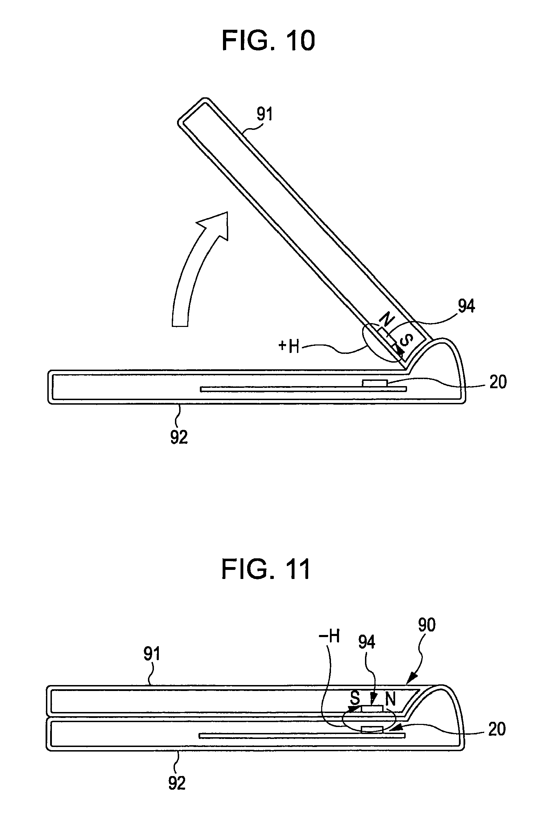

Conversely, when the foldable cellular phone 90 is opened as shown in Fig. 10, the first member 91 is gradually withdrawn from the second member 92, accordingly the magnitude of the external magnetic field (+H) that acts on the magnetic detection device 20 gradually becomes smaller, and then the magnitude of the external magnetic field (+H) acting on the magnetic detection device 20 becomes zero. The magnitude of the external magnetic field (+H) acting on the magnetic detection device 20 is not more than a predetermined value, whereby the foldable cellular phone 90 is detected in an open state. For example, a backlight in a rear side of the liquid crystal display or the manipulation buttons is controlled to emit light by a control unit built in the foldable cellular phone 90.

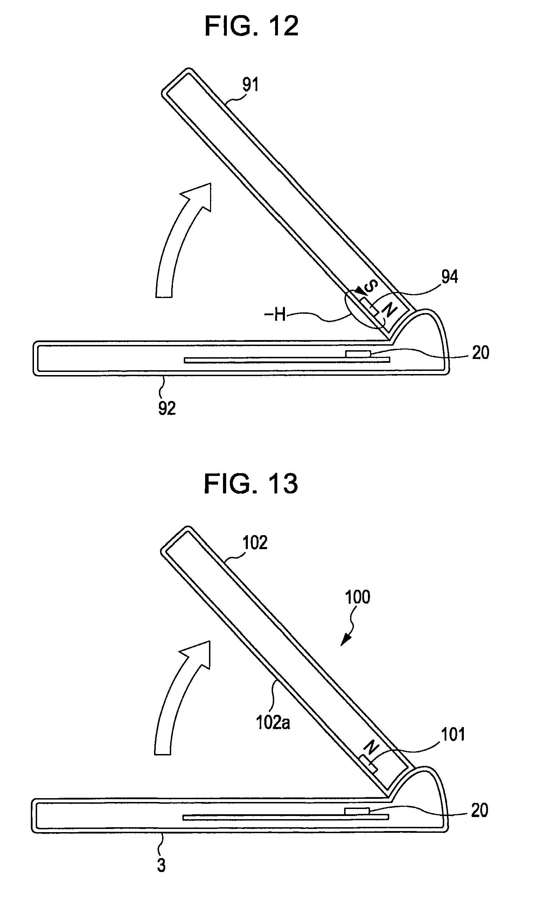

The magnetic detection device 20 according to the embodiment is the NS detection sensor. That is, an N pole of the magnet 94 is disposed on a left side of the illustration portion of the magnet and an S pole is disposed on a right side of the illustration portion in Fig. 9. On the contrary, when the polarity is inversely disposed as shown in Fig. 11(the N pole is at the right side and the S pole is at the left side), the direction of the external magnetic field (-H) acting on the magnetic detection device 20 (hereinafter, it is called negative direction) is reversed to the direction of the external magnetic field (+H) in Fig. 1. In the embodiment, even in such a condition, the open operation of the foldable cellular phone 90 can be properly detected when the folding state of the cellular phone 90 in Fig. 11 is changed into the opening state of the cellular phone 90 in Fig. 12.

Accordingly, the magnet 94 can be disposed without any consideration about the polarity of the external magnetic field, therefore there in no limitation in the disposition of the magnet 94, and the assembly of the foldable cellular phone is easy.

In the aforementioned opening/closing detection method, though it is not possible to detect a direction of an external magnetic field, it is enough to detect only the change of the external magnetic field by the dipole. Accordingly, for example, any one of the external output terminals 40 and 41 illustrated in Figs. 1 and 2 may be provided.

That is, for example, if the second switch circuit 43 in Fig. 1 and Fig. 2 is removed, and one signal line to from the comparator 38 to the output terminal 40 through the latch circuit 46 and the FET circuit 54 is formed, both of a detection signal of an external magnetic field in the positive direction (+H) and a detection signal of an external magnetic field in the negative direction (-H) can be obtained from the external output terminal 40. In this case, both of the detection signals are, for example, low level signals as above mentioned. Accordingly, it is not possible to determine whether the signals are the detection signals of the positive direction or negative direction of the external magnetic field. However, there is no need to detect the direction of the external magnetic field in the opening/closing detection. Therefore, it is possible to use just one external output terminal, and further simplify the circuit configuration.

By contrast, in case of operating variable functions according to the direction of the external magnetic field, such as a foldable cellular phone 100 of a turn over type as mentioned below, it is preferable to configure the magnetic detection device by providing external output terminals 40 and 41 as shown in Fig. 1 and Fig. 2 such that the direction of the external magnetic field can also be detected.

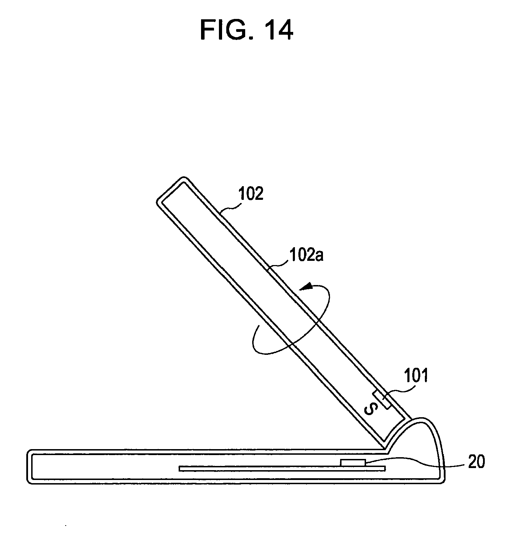

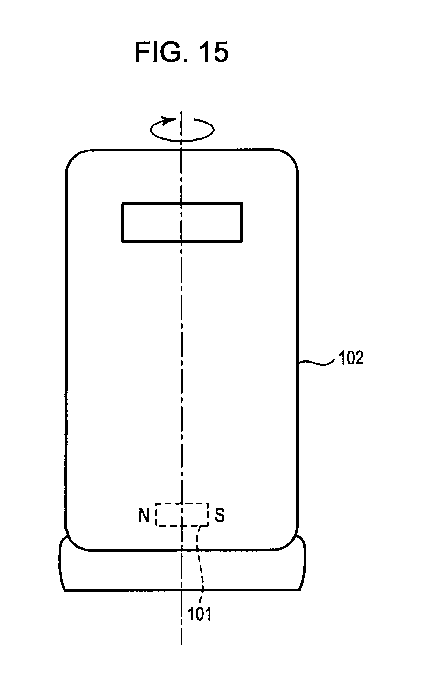

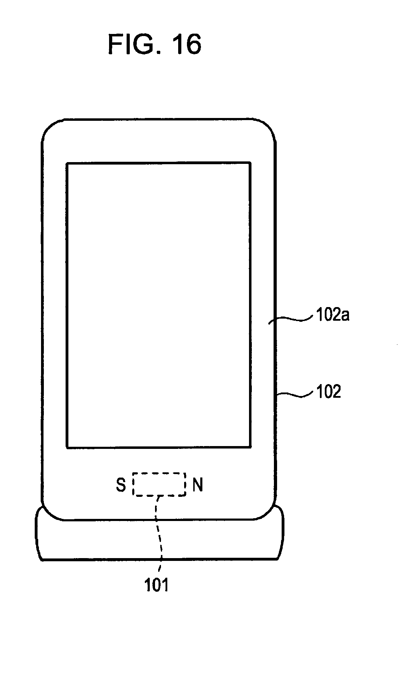

When the foldable cellular phone 100 is opened as shown Fig. 13, the opening state of the foldable cellular phone is detected according to the intensity variation of the external magnetic field acting on the magnetic detection device 20 as illustrated in Fig. 10 and Fig. 12. An arrangement of a magnet 101 in Fig. 13 is the same as a top view in Fig. 15, the first member 102 of the foldable cellular phone 100 is rotated by 180 degrees about a rotation axis, so that a screen display surface 102a located on an inside of the first member 102 in the state of Fig. 13 is set to face outside as shown in Fig. 14 and Fig. 16. Whereby the direction of the magnet 101 in Fig. 16 is reversed from the disposition state in Fig. 15. For example, when a camera function is operated by turning over the first member 102, the magnetic detection device 20 should detect the reversing state in the direction of the magnet 101 in addition to the opening/closing detection function for detecting opening and closing of the cellular phone 100 shown in Fig. 13. However, the magnetic detection device 20 according to the embodiment can detect whether the detection signal of the positive directional external magnetic field (+H) or the detection signal of the negative directional external magnetic field (-H) by the circuit configuration in Fig. 1 and Fig. 2 by providing the two output terminals 40 and 41.

The element configuration of the sensor unit 21 according to the embodiment is just an example, and there is no need to be limited in the element configuration. In the embodiment, the first bridge circuit BC3 detects the external magnetic field of the positive direction (+H) and the second bridge circuit BC4 detects the external magnetic field of the negative direction (-H). However, in addition that the two bridge circuits BC3 and BC4 detect the external magnetic fields of the positive direction and the negative direction, a series circuit commonly used by the brides may be provided. For example, in the element configuration of the sensor unit 21 according to the embodiment, the fifth and the sixth resistance elements 31 and 34 which are commonly used by the first bridge circuit BC3 and the second bridge circuit BC4 are the fixed resistance elements which are not varied to the external magnetic field. Therefore, by setting a fixed potential at the third output extracting portion 33 as a reference potential, differential potentials of the first bridge circuit BC3 and the second bridge circuit BC4 are generated. Accordingly, the differential potential is smaller than that in the conventional sensor configuration in Fig. 17.

Accordingly, to obtain a differential potential equivalent to the differential potential in the conventional sensor configuration, the fifth resistance element 31 illustrated in Fig. 1 and Fig. 2 may be formed of the same magneto-resistance effect element as the first magneto-resistance effect element 23 disposed in the first series circuit 26, and the sixth resistance element 32 may be formed of the same magneto-resistance effect element as the second magneto-resistance effect element 27 disposed in the second series circuit 30.

Alternatively, the second resistance element 24 connected to the first series circuit 26 shown in Fig. 1 and Fig. 2, and the fourth resistance element 28 connected to the second series circuit 30 are the fixed resistance elements that do not vary to the external magnetic field. However, for example, the second resistance element 24 may be formed of a magneto-resistance effect element that has an electrical resistance variable to the positive directional external magnetic field (+H), and has an inverse pattern in increase and decrease of the resistance to the intensity variation of the external magnetic field as compared with the first magneto-resistance effect element 23. Further, the fourth resistance element 28 may be formed of a magneto-resistance effect element that has an electrical resistance variable to the negative directional external magnetic field (-H), and has an inverse pattern in increase and decrease of the resistance to the intensity variation of the external magnetic field as compared with the second magneto-resistance effect element 27. Then, the differential potential may be increased and the detection sensitivity may have good performance.

In the embodiment illustrated in Fig. 1 and Fig. 2, in the first bridge circuit BC3 including the first series circuit 26 and the third series circuit 34, and the second bridge circuit BC4 including the second series circuit 30 and the third series circuit 34, as a reference state of a zero external magnetic field (non magnetic field state), when the external magnetic field gradually increase in the positive direction and the negative direction, increase and decrease patterns of the differential potentials are the same when the positive directional external magnetic field and the negative directional external magnetic field are applied. As described above, by forming the bridge circuits to have the same increase and decrease patterns in the differential potentials, it is not necessary to change the Schmitt trigger input value of the comparator 38 depending on whether the positive directional external magnetic field is applied or the negative directional external magnetic field is applied. Accordingly, the control is easy and it is enough to use one comparator 38.

Further, in the embodiment, the switch circuits 36, 43, and 48 are described as the first connection switch portion, the second connection switch portion, and the third connection switch portion. However, it is not limited to the switch circuits. Alternatively, it may be possible to use active elements having switching functions.

Moreover, it is selectable whether or not to apply a bias magnetic field on the magneto-resistance effect element. It is not necessary to apply the bias magnetic field to the free magnetic layer included in the magneto-resistance effect element. If the bias magnetic field is applied, for example, a magnetization of the fixed magnetic layer and the free magnetic layer is to be controlled to be orthogonal to each other in a non magnetic field state.

Further more, the magnetic detection device 20 according to the present invention may be available for opening/closing detection of an electronic device such as a game device and the like, other than the opening/closing detection of the foldable cellular phone. The embodiment is also available for not only the opening/closing detection mentioned above, but also a use the magnetic detection device 20 of the NS detection type is required.

### Brief Description of Drawings

[Fig. 1] Fig. 1 is a circuit diagram illustrating a state of an external magnetic field detection circuit in the positive direction of a magnetic detection device according to an embodiment of the invention.
[Fig. 2] Fig. 2 is a circuit diagram illustrating a state of the external magnetic field detection circuit in the negative direction of the magnetic detection device according to an embodiment.
[Fig. 3] Fig. 3 is a graph (curve R-H) illustrating a hysteresis characteristic of a first magneto-resistance effect element.
[Fig. 4] Fig. 4 is a graph (curve R-H) illustrating a hysteresis characteristic of a second magneto-resistance effect element.
[Fig. 5] Fig. 5 is a partially enlarged perspective view of the magnetic detection device 20 illustrating a shape of a resistance element of a sensor unit of the magnetic detection device 20 according to the embodiment.
[Fig. 6] Fig. 6 is a partially sectional view of the magnetic detection device taken along Line A-A of Fig. 5 in a thickness direction as viewed in the direction of an arrow.
[Fig. 7] Fig. 7 is a partially sectional view illustrating layer structures of the first magneto-resistance and the second magneto-resistance.
[Fig. 8] Fig. 8 is a partially sectional view mainly illustrating a layer structure of a fixed resistance element.
[Fig. 9] Fig. 9 is an example illustrating a use of the magnetic detection device according to the embodiment (a partially schematic view of a foldable cellular phone having the magnetic detection device when the cellular phone is folded).
[Fig. 10] Fig. 10 is an example illustrating the use of the magnetic detection device according to the embodiment (a partially schematic view of the foldable cellular phone having the magnetic detection device when the cellular phone is opened).
[Fig. 11] Fig. 11 is an example illustrating the use of the magnetic detection device according to the embodiment (a partially schematic view of the foldable cellular phone having the magnetic detection device and a magnet disposed in opposite direction of Fig. 9 when the cellular phone is folded).
[Fig. 12] Fig. 12 is an example illustrating the use of the magnetic detection device according to the embodiment (a partially schematic view of the foldable cellular phone having the magnetic detection device and a magnet disposed in opposite direction of Fig. 10 when the cellular phone is opened).
[Fig. 13] Fig. 13 is an example illustrating the use of the magnetic detection device according to the embodiment (a partially schematic view of the foldable cellular phone having the magnetic detection device when the cellular phone is opened).
[Fig. 14] Fig. 14 is an example illustrating the use of the magnetic detection device according to the embodiment (a partially schematic view of the foldable cellular phone having the magnetic detection device when a first member is turned over).
[Fig. 15] Fig. 15 is an example illustrating the use of the magnetic detection device according to the embodiment (a partially plan view of the foldable cellular phone having the magnetic detection device illustrated in Fig. 13).
[Fig. 16] Fig. 16 is an example illustrating the use of the magnetic detection device according to the embodiment (a partially plan view of the foldable cellular phone having the magnetic detection device illustrated in Fig. 15).
[Fig. 17] Fig. 17 is a circuit diagram illustrating a known magnetic detection device.

### Reference Numerals

- 20: magnetic detection device
- 21: sensor unit
- 22: integrated circuit (IC)
- 23: first magneto-resistance effect element (first resistance element)
- 24: fixed resistance element (second resistance element)
- 25: first output extracting portion
- 26: first series circuit
- 27: second magneto-resistance effect element (third resistance element)
- 28: fixed resistance element (fourth resistance element)
- 29: second output extracting portion
- 30: second series circuit
- 31: fixed resistance element (fifth resistance element)
- 32: fixed resistance element (sixth resistance element)
- 33: third output extracting portion
- 34: third series circuit
- 35: differential amplifier
- 36: first switch circuit (first connection switch portion)
- 38: comparator
- 39: input terminal
- 40: first external output terminal
- 41: second external output terminal
- 42: earth terminal
- 43: second switch circuit
- 46, 47: latch circuits
- 48: third switch circuit
- 53: clock circuit
- 62: antiferromagnetic layer
- 63: fixed magnetic layer (first magnetic layer)
- 64: non-magnetic intermediate layer
- 65, 67: free magnetic layers (second magnetic layers)
- 78, 80: insulating layers
- 81: mold resin
- 90, 100: foldable cellular phones
- 91, 102: first members
- 92: second member
- 94, 101: magnets

## Claims

1. A magnetic detection device (20) comprising:
a first series circuit (26);
a second series circuit (30); and
a third series circuit (34), wherein at least one of a plurality of resistance elements (23, 24) forming the first series circuit (26) includes a first magneto-resistance effect element (23) using a magneto-resistance effect;
wherein at least one of a plurality of resistance elements (27, 28) forming the second series circuit (30) includes a second magneto-resistance effect element (27) using a second magneto-resistance effect,;
wherein a plurality of resistance elements (31, 32) forming the third series circuit (34) are common resistance elements (31, 32) connected to the resistance elements (23, 24) of the first series circuit (26) and the resistance elements (27, 28) of the second series circuit (30) in a bridge manner respectively;
wherein a first output extracting portion (25) of the first series circuit (26) and a second output extracting portion (29) of the second series circuit (30) are individually connected to a common differential output portion (35) through a first connection switch portion (36) and a third output extracting portion (33) of the third series circuit (34) is connected to the common differential output portion (35), and
wherein a first bridge circuit (BC3) for detecting the external magnetic field of the (+H) direction including the first series circuit (26) and the third series circuit (34) connected in parallel to each other is configured to be switched to a connection state with the differential output portion (35) when the first output extracting portion (25) is connected to the differential output portion (35) by the first connection switch portion (36), and a second bridge circuit (BC4) for detecting the external magnetic field of the (-H) direction including the second series circuit (30) and the third series circuit (34) connected in parallel to each other is configured to be switched to a connection state with the differential output portion (35) when the second output extracting portion (29) is connected to the differential output portion (35) by the first connection switch portion (36)**characterized in that**
the first magneto-resistance effect element (23) is configured such that an electric resistance varies with an external magnetic field of a (+H) direction and the magnetization (65a) of a free layer (65) of the at least one magneto-resistance effect element (23) of the first circuit (26) does not vary with an external magnetic field of a (-H) direction that is an opposite direction of the (+H) direction;
a second magneto-resistance effect element (27) is configured such that an electric resistance varies with the external magnetic field of (-H) direction and the magnetization (67a) of a free layer (67) of the at least one magneto-resistance effect element (27) of the second circuit (30) does not vary with the external magnetic field of the (+H) direction,
wherein the first resistance element (23) and the second resistance element (24) of the first series circuit (26) are connected in series through the first output extracting portion (25), and the first resistance element (23) is formed of the first magneto-resistance effect element (23);
wherein a third resistance element (27) and a fourth resistance element (28) of the second series circuit (30) are connected in series through the second output extracting portion (29), and the third resistance element (27) is formed of the second magneto-resistance effect element (27);
wherein a fifth resistance (31) element and a sixth resistance element (32) of the third series circuit (34) are connected in series through the third output extracting portion (33);
wherein the first resistance element (23) is connected in parallel to the sixth resistance element (32) and the second resistance element (24) is parallel to the fifth resistance element (31), thereby forming the first bridge circuit (BC3), and
wherein the third resistance (27) element is parallel to the fifth resistance element (31) and the fourth resistance element (28) is connected in parallel to the sixth resistance element (32), thereby forming the second bridge circuit (BC4).

2. The magnetic detection device (20) according to claim 1, further comprising:
a first external output terminal (40);
a second external output terminal (41), and
a second connection switch portion (43) for switching over a connection between the differential output portion (35) and the first external output terminal (40) and a connection between the differential output portion (35) and the second external output terminal (41), wherein the differential output portion (35) and the first external output terminal (40) are connected to each other by the second connection switch portion (43) when the first output extracting portion (25) and the differential output portion (35) are connected to each other by the first connection switch portion (36), and the differential output portion (35) and the second external output terminal (41) are connected to each other by the second connection switch portion (43) when the second output extracting portion (29) and the differential output portion (35) are connected to each other by the first connection switch portion (36),
the device being configured such that a (+H) detection signal is outputted from the first external output terminal (40) on the basis of the variation of the electric resistance of the first magneto-resistance effect element (23) when the external magnetic field of the (+H) direction acts, and a (-H) detection signal is outputted from the second external output terminal (41) on the basis of the variation of the electric resistance of the second magneto-resistance effect element (27) when the external magnetic field of the (-H) direction acts.

3. The magnetic detection device (20) according to any one of claims 1 or 2, further comprising a third connection switch portion for switching over a connection between at least one of an input terminal (39) and an earth terminal (42) and the first series circuit (26), and a connection between the one terminal (39, 42) and the second series circuit (30),
wherein the first series circuit (26) and the one terminal (39, 42) are connected to each other by the third connection switch portion when the first output extracting portion (25)
and the differential output portion (35) are connected to each other by the first connection switch portion (36), and the second series circuit (30) and the one terminal are connected to each other by the third connection switch portion when the second output extracting portion (29) and the differential output portion (35) are connected to each other by the first connection switch portion (36).

4. The magnetic detection device (20) according to any one of claim 1 to 3, wherein a first inter-layer coupling magnetic field Hin1 that acts on between a fixed magnetic layer (63) and a free magnetic layer (65) of the first magneto-resistance effect element (23) is shifted to the external magnetic field in the (₊H) direction on a curve R-H, and a second inter-layer coupling magnetic field Hin2 that acts on between a fixed magnetic layer (63) and a free magnetic layer (67) of the second magneto-resistance effect element (27) is shifted to the external magnetic field in the (-H) direction on the curve R-H.

5. The magnetic detection device (20) according to claim 4, wherein magnetization directions of the fixed magnetic layers (63) of the first magneto-resistance effect element (23) and the second magneto-resistance effect element (27) are the same, and the directions are fixed to the (+H) direction or the (-H) direction, a magnetization direction of the free magnetic layer (65) of the first magneto-resistance effect (23) element is the (-H) direction in a non-magnetic field state, and a magnetization direction of the free magnetic layer (67) of the second magneto-resistance effect element (27) is the (+H) direction in the non-magnetic field state.

## Patentansprüche

1. Magnetdetektionsvorrichtung (20) aufweisend:
eine erste Reihenschaltung (26);
eine zweite Reihenschaltung (30); und
eine dritte Reihenschaltung (34), wobei wenigstens eines von mehreren Widerstandselementen (23, 24), welche die erste Reihenschaltung (26) bilden, ein erstes Magnetwiderstandseffektelement (23) enthält, das einen Magnetwiderstandseffekt nutzt;
wobei wenigstens eines von mehreren Widerstandselementen (27, 28), welche die zweite Reihenschaltung (30) bilden, ein zweites Magnetwiderstandseffektelement (27) enthält, das einen zweiten Magnetwiderstandseffekt nutzt;
wobei mehrere Widerstandselemente (31, 32), welche die dritte Reihenschaltung (34) bilden, gewöhnliche Widerstandselemente (31, 32) sind, die mit den Widerstandselementen (22, 24) der ersten Reihenschaltung (26) und den Widerstandselementen (27, 28) der zweiten Reihenschaltung (30) jeweils brückenartig verbunden sind;
wobei ein erster Ausgangswertentnahmebereich (25) der ersten Reihenschaltung (26) und ein zweiter Ausgangswertentnahmebereich (29) der zweiten Reihenschaltung (30) individuell durch einen ersten Verbindungsschaltbereich (36) mit einem gemeinsamen Differenzausgabebereich (35) verbunden sind, und ein dritter Ausgangswertentnahmebereich (33) der dritten Reihenschaltung (34) mit dem gemeinsamen Differenzausgabebereich (35) verbunden ist, und
wobei eine erste Brückenschaltung (BC3) zum Erkennen des externen magnetischen Feldes in der (+H)-Richtung, welche die erste Reihenschaltung (26) und die dritte Reihenschaltung (34) enthält, die parallel miteinander verbunden sind, eingerichtet ist, in einen Zustand geschaltet zu werden, in dem sie mit dem Differenzausgabebereich (35) verbunden ist, wenn der erste Ausgangswertentnahmebereich (25) durch den ersten Verbindungsschaltbereich (36) mit dem Differenzausgabebereich (35) verbunden ist, und eine zweite Brückenschaltung (BC4) zum Erkennen des externen magnetischen Feldes in der (-H)-Richtung, welche die zweite Reihenschaltung (30) und die dritte Reihenschaltung (34) enthält, die parallel miteinander verbunden sind, eingerichtet ist, in einen Zustand geschaltet zu werden, in dem sie mit dem Differenzausgabebereich (35) verbunden ist, wenn der zweite Ausgangswertentnahmebereich (29) durch den ersten Verbindungsschaltbereich (36) mit dem Differenzausgabebereich (35) verbunden ist, **dadurch gekennzeichnet, dass**
das erste Magnetwiderstandseffektelement (23) so eingerichtet ist, dass sich ein elektrischer Widerstand mit einem externen magnetischen Feld in der (+H)-Richtung verändert, und sich die Magnetisierung (65a) einer freien Schicht (65) des wenigstens einen Magnetwiderstandseffektelements (23) der ersten Schaltung (26) mit einem externen magnetischen Feld in der (-H)-Richtung, die der Richtung der (+H)-Richtung entgegengesetzt ist, nicht verändert;
ein zweites Magnetwiderstandseffektelement (27) so eingerichtet ist, dass sich ein elektrischer Widerstand mit einem externen magnetischen Feld in der (-H)-Richtung verändert, und sich die Magnetisierung (67a) einer freien Schicht (67) wenigstens eines Magnetwiderstandseffektelements (27) der zweiten Schaltung mit dem externen magnetischen Feld in der (+H)-Richtung nicht verändert,
wobei das erste Widerstandselement (23) und das zweite Widerstandselement (24) der ersten Reihenschaltung (26) durch den ersten Ausgangswertentnahmebereich (25) in Reihe verbunden sind, und das erste Widerstandselement (23) aus dem ersten Magnetwiderstandselement (23) ausgebildet ist;
wobei ein drittes Widerstandselement (27) und ein viertes Widerstandselement (28) der zweiten Reihenschaltung (30) durch den zweiten Ausgangswertentnahmebereich (29) in Reihe verbunden sind, und das dritte Widerstandselement (27) aus dem zweiten Magnetwiderstandseffektelement (27) ausgebildet ist;
wobei ein fünftes Widerstandselement (31) und ein sechstes Widerstandselement (32) der dritten Reihenschaltung (34) durch den dritten Ausgangswertentnahmebereich (33) in Reihe verbunden sind;
wobei das erste Widerstandselement (23) parallel zu dem sechsten Widerstandselement (32) verbunden ist, und das zweite Widerstandselement (24) parallel zu dem fünften Widerstandselement (31) ist, wodurch sie die erste Brückenschaltung (BC3) ausbilden, und
wobei das dritte Widerstandselement (27) parallel zu dem fünften Widerstandselement (31) und das vierte Widerstandselement (28) parallel zu dem sechsten Widerstandselement (32) verbunden ist, wodurch sie die zweite Brückenschaltung (BC4) ausbilden.

2. Magneterkennungsvorrichtung (20) nach Anspruch 1 zusätzlich aufweisend:
einen ersten externen Ausgangsanschluss (40);
einen zweiten externen Ausgangsanschluss (41), und
einen zweiten Verbindungsschaltbereich (43), um eine Verbindung zwischen dem Differenzausgabebereich (35) und dem ersten externen Ausgangsanschluss (40) und eine Verbindung zwischen dem Differenzausgabebereich (35) und dem zweiten externen Ausgangsanschluss (41) umzuschalten, wodurch der Differenzausgabebereich (35) und der erste externe Ausgangsanschluss (40) durch den zweiten Verbindungsschaltbereich (43) miteinander verbunden sind, wenn der erste Ausgangswertentnahmebereich (25) und der Differenzausgabebereich (35) durch den ersten Verbindungsschaltbereich (36) miteinander verbunden sind, und der Differenzausgabebereich (35) und der zweite externe Ausgabeanschluss (41) durch den zweiten Verbindungsschaltbereich (43) miteinander verbunden sind, wenn der zweite Ausgangswertentnahmebereich (29) und der Differenzausgabebereich (35) durch den ersten Verbindungsschaltbereich (36) miteinander verbunden sind,
wobei die Vorrichtung so eingerichtet ist, dass basierend auf der Veränderung des elektrischen Widerstandes des ersten Magnetwiderstandseffektelements (23) von dem ersten externen Ausgangsanschluss (40) ein (+H)-Erkennungssignal ausgegeben wird, wenn ein externes magnetisches Feld in der (+H)-Richtung wirkt, und basierend auf der Veränderung des elektrischen Widerstandes des zweiten Magnetwiderstandseffektelements (27) von dem zweiten externen Ausgangsanschluss (41) ein (-H)-Erkennungssignal ausgegeben wird, wenn das externe magnetische Feld in der (-H)-Richtung wirkt.

3. Magneterkennungsvorrichtung (20) nach einem der Ansprüche 1 oder 2, zusätzlich aufweisend einen dritten Verbindungsschaltbereich zum Umschalten einer Verbindung zwischen wenigstens einem von einem Eingangsanschluss (39) und einem Erdungsanschluss (42) und der ersten Reihenschaltung (26), und einer Verbindung zwischen dem einen Anschluss (39, 42) und der zweiten Reihenschaltung (30),
wobei die erste Reihenschaltung (26) und der eine Anschluss (39, 42) durch den dritten Verbindungsschaltbereich miteinander verbunden sind, wenn der erste Ausgangswertentnahmebereich (25) und der Differenzausgabebereich (35) durch den ersten Verbindungsschaltbereich (36) miteinander verbunden sind, und die zweite Reihenschaltung (30) und der eine Anschluss durch den dritten Verbindungsschaltbereich miteinander verbunden sind, wenn der zweite Ausgangswertentnahmebereich (29) und der Differenzausgabebereich (35) durch den ersten Verbindungsschaltbereich (36) miteinander verbunden sind.

4. Magneterkennungsvorrichtung (20) nach einem der Ansprüche 1 bis 3, wobei eine erstes Zwischenschicht-Kopplungsmagnetfeld Hin1, das zwischen einer fixierten magnetischen Schicht (36) und einer freien magnetischen Schicht (65) des ersten Magnetwiderstandseffektelements (23) wirkt, durch das externe magnetische Feld auf einer Kurve R-H in (+H)-Richtung verschoben wird, und ein zweites Zwischenschicht-Kopplungsmagnetfeld Hin2, das zwischen einer fixierten magnetischen Schicht (63) und einer freien magnetischen Schicht (67) des zweiten Magnetwiderstandseffektelements (27) wirkt, durch das externe magnetische Feld auf der Kurve R-H in (-H)-Richtung verschoben wird.

5. Magneterkennungsvorrichtung (20) nach Anspruch 4, wobei die Magnetisierungsrichtungen der fixierten magnetischen Schichten (63) des ersten Magnetwiderstandseffektelements (23) und des zweiten Magnetwiderstandseffektelements (27) die gleichen sind, und die Richtungen in der (+H)-Richtung oder in der (-H)-Richtung fixiert sind, eine Magnetisierungsrichtung der freien magnetischen Schicht (65) des ersten Magnetwiderstandseffektelements (23) in einem magnetfeldfreien Zustand die (-H)-Richtung ist, und eine Magnetisierungsrichtung der freien magnetischen Schicht (67) des zweiten Magnetwiderstandseffektelements (27) in einem magnetfeldfreien Zustand die (+H)-Richtung ist.

## Revendications

1. Dispositif de détection magnétique (20) comportant :
un premier circuit série (26) ;
un deuxième circuit série (30) ; et
un troisième circuit série (34), dans lequel au moins un élément parmi une pluralité d'éléments résistifs (23, 24) formant le premier circuit série (26) comprend un élément à effet magnétorésistif (23) utilisant un effet de magnétorésistance ;
dans lequel au moins un élément parmi une pluralité d'éléments résistifs (27, 28) formant le deuxième circuit série (30) comprend un deuxième élément à effet magnétorésistif (27) utilisant un deuxième effet de magnétorésistance ;
dans lequel une pluralité d'éléments résistifs (31, 32) formant le troisième circuit série (34) sont des éléments résistifs communs (31, 32) montés en pont respectivement avec les éléments résistifs (23, 24) du premier circuit série (26) et les éléments résistifs (27, 28) du deuxième circuit série (30) ;
dans lequel un premier moyen d'extraction de sortie (25) du premier circuit série (26) et un deuxième moyen d'extraction de sortie (29) du deuxième circuit série (30) sont connectés individuellement à un moyen de sortie différentielle commun (35) par un premier moyen de commutation de connexion (36) et un troisième moyen d'extraction de sortie (33) du troisième circuit série (34) est connecté au moyen de sortie différentielle commun (35), et
dans lequel un premier montage en point (BC3) pour détecter le champ magnétique externe à direction (+H) comprenant le premier circuit série (26) et le troisième circuit série (34) montés en parallèle l'un avec l'autre est conçu pour passer à un état de connexion avec le moyen de sortie différentielle (35) quand le premier moyen d'extraction de sortie (25) est connecté au moyen de sortie différentielle (35) par le premier moyen de commutation de connexion (36), et un deuxième montage en pont (BC4) pour détecter le champ magnétique externe à direction (-H) comprenant le deuxième circuit série (30) et le troisième circuit série (34) montés en parallèle l'un avec l'autre est conçu pour passer à un état de connexion avec le moyen de sortie différentielle (35) quand le deuxième moyen d'extraction de sortie (29) est connecté au moyen de sortie différentielle (35) par le premier moyen de commutation de connexion (36) ; **caractérisé en ce que**
le premier élément à effet magnétorésistif (23) est conçu de façon qu'une résistance électrique varie avec un champ magnétique externe à direction (+H) et que l'aimantation (65a) d'une couche libre (65) du/des élément(s) magnétorésistif(s) (23) du premier circuit (26) ne varie pas avec un champ magnétique externe à direction (-H) qui est une direction opposée à la direction (+H) ;
un deuxième élément à effet magnétorésistif (27) est conçu de façon qu'une résistance électrique varie avec un champ magnétique externe à direction (-H) et que l'aimantation (67a) d'une couche libre (67) du/des élément(s) magnétorésistif(s) (27) du deuxième circuit (30) ne varie pas avec un champ magnétique externe à direction (+H) ;
le premier élément résistif (23) et le deuxième élément résistif (24) du premier circuit série (26) étant montés en série par l'intermédiaire du premier moyen d'extraction de sortie (25), et le premier élément résistif (23) étant constitué par le premier élément à effet de magnétorésistance (23) ;
un troisième élément résistif (27) et un quatrième élément résistif (28) du deuxième circuit série (30) étant montés en série par l'intermédiaire du deuxième moyen d'extraction de sortie (29), et le troisième élément résistif (27) étant constitué par le deuxième élément à effet de magnétorésistance (27) ;
un cinquième élément résistif (31) et un sixième élément résistif (32) du troisième circuit série (34) étant montés en série par l'intermédiaire du troisième moyen d'extraction de sortie (33) ;
le premier élément résistif (23) étant monté en parallèle avec le sixième élément résistif (32) et le deuxième élément résistif (24) étant parallèle au cinquième élément résistif (31), en formant de ce fait le premier montage en pont (BC3), et
le troisième élément résistif (27) étant parallèle au cinquième élément résistif (31) et le quatrième élément résistif (28) étant monté en parallèle avec le sixième élément résistif (32), en formant de ce fait le deuxième montage en pont (BC4).

2. Dispositif de détection magnétique (20) selon la revendication 1, comportant en outre :
une première borne extérieure de sortie (40) ;
une seconde borne extérieure de sortie (41), et
un deuxième moyen de commutation de connexion (43) pour commuter sur une connexion entre le moyen de sortie différentielle (35) et la première borne extérieure de sortie (40) et une connexion entre le moyen de sortie différentielle (35) et la seconde borne extérieure de sortie (41), le moyen de sortie différentielle (35) et la première borne extérieure de sortie (40) étant connectés l'un à l'autre par le deuxième moyen de commutation de connexion (43) quand le premier moyen d'extraction de sortie (25) et le moyen de sortie différentielle (35) sont connectés l'un à l'autre par le premier moyen de commutation de connexion (36), et le moyen de sortie différentielle (35) et la seconde borne extérieure de sortie (41) étant connectés l'un à l'autre par le deuxième moyen de commutation de connexion (43) quand le deuxième moyen d'extraction de sortie (29) et le moyen de sortie différentielle (35) sont connectés l'un à l'autre par le premier moyen de commutation de connexion (36),
le dispositif étant conçu de façon qu'un signal de détection de (+H) soit délivré par la première borne extérieure de sortie (40) d'après la variation de la résistance électrique du premier élément à effet de magnétorésistance (23) quand c'est le champ magnétique externe à direction (+H) qui agit, et qu'un signal de détection de (-H) soit délivré par la seconde borne extérieure de sortie (41) d'après la variation de la résistance électrique du deuxième élément à effet de magnétorésistance (27) quand c'est le champ magnétique externe à direction (-H) qui agit.

3. Dispositif de détection magnétique (20) selon l'une quelconque des revendications 1 et 2, comportant en outre un troisième moyen de commutation de connexion pour commuter sur une connexion entre une borne d'entrée (39) et/ou une borne de terre (42) et le premier circuit série (26), et une connexion entre la/les borne(s) (39, 42) et le deuxième circuit série (30),
le premier circuit série (26) et la/les borne(s) (39, 42) étant connectés l'un à l'autre/les uns aux autres par le troisième moyen de commutation de connexion quand le premier moyen d'extraction de sortie (25) et le moyen de sortie différentielle (35) sont connectés l'un à l'autre par le premier moyen de commutation de connexion (36), et le deuxième circuit série (30) et la/les borne(s) étant connectés l'un à l'autre/les uns aux autres par le troisième moyen de commutation de connexion quand le deuxième moyen d'extraction de sortie (29) et le moyen de sortie différentielle (35) sont connectés l'un à l'autre par le premier moyen de commutation de connexion (36).

4. Dispositif de détection magnétique (20) selon l'une quelconque des revendications 1 à 3, dans lequel une première couche intercalaire couplant un champ magnétique Hin1 qui agit entre une couche magnétique fixe (63) et une couche magnétique libre (65) du premier élément à effet de magnétorésistance (23) passe au champ magnétique externe à direction (+H) sur une courbe R-H, et une seconde couche intercalaire couplant un champ magnétique Hin2 qui agit entre une couche magnétique fixe (63) et une couche magnétique libre (67) du deuxième élément à effet de magnétorésistance (27) passe au champ magnétique externe à direction (-H) sur la courbe R-H.

5. Dispositif de détection magnétique (20) selon la revendication 4, dans lequel des directions d'aimantation des couches magnétiques fixes (63) du premier élément à effet de magnétorésistance (23) et du deuxième élément à effet de magnétorésistance (27) sont les mêmes, et les directions sont fixées à la direction (+H) ou à la direction (-H), une direction d'aimantation de la couche magnétique libre (65) du premier élément à effet de magnétorésistance (23) est la direction (-H) dans un état de champ amagnétique et une direction d'aimantation de la couche magnétique libre (67) du deuxième élément à effet de magnétorésistance (27) est la direction (+H) dans l'état de champ amagnétique.
